Europäisches Patentamt

(19) European Patent Office

Office européen des brevets

(11) Veröffentlichungsnummer: **0 023 538**
**B1**

(12) **EUROPÄISCHE PATENTSCHRIFT**

(45) Veröffentlichungstag der Patentschrift:
12.09.84

(21) Anmeldenummer: 80102652.7

(22) Anmeldetag: 13.05.80

(51) Int. Cl.³: **G 11 C 11/40,** G 11 C 8/00,
.G 11 C 11/24, H 01 L 27/02

(54) Halbleiterspeicherzelle in MTL-Technik.

(30) Priorität: 30.07.79 US 61973

(43) Veröffentlichungstag der Anmeldung:
11.02.81 Patentblatt 81/6

(45) Bekanntmachung des Hinweises auf die Patenterteilung:
12.09.84 Patentblatt 84/37

(84) Benannte Vertragsstaaten:
DE FR GB NL SE

(56) Entgegenhaltungen:
EP - A - 0 012 796
US - A - 3 675 218
US - A - 3 761 898
US - A - 3 986 178
US - A - 4 032 902
US - A - 4 112 511
US - A - 4 125 877
US - A - 4 127 899

IBM TECHNICAL DISCLOSURE BULLETIN, Band 13, Nr.
3, August 1970, New York, US, A.R. BERDING:
"Simultaneous read-write monolithic storage cell",
Seite 620
IBM TECHNICAL DISCLOSURE BULLETIN, Band 14, Nr.
6, November 1971, New York, US, S.K. WIEDMANN:
"Random access memory cell", Seiten 1721-1722

(73) Patentinhaber: International Business Machines
Corporation, Old Orchard Road, Armonk, N.Y. 10504 (US)

(72) Erfinder: Denis, Bernard Albert, 9 Rue des Mûres,
Mennecy 91540 (FR)

(74) Vertreter: Brügel, Gerhard, Dipl.-Ing., Schönaicher
Strasse 220, D-7030 Böblingen (DE)

(56) Entgegenhaltungen: (Fortsetzung)
IBM TECHNICAL DISCLOSURE BULLETIN, Band 17, Nr.
6, November 1974, New York, US, J.A. DORLER et al.:
"Lateral PNP design for memory cell", Seiten 1619-1620
REVIEW OF THE ELECTRICAL COMMUNICATION
LABORATORIES, Band 21, Nr.7-8, Juli-August 1973,
Tokyo, JP, N. IEDA et al.: "High speed MOS memory",
Seiten 473-481
IBM TECHNICAL DISCLOSURE BULLETTIN, Band 16,
Nr. 12, Mai 1974, New York, US, H.H. BERGER et al:
"Associative memory cell", Seiten 3963-3964
IEEE JOURNAL OF SOLID-STATE CIRCUITS, Band
SC-10, Nr. 5, Oktober 1975, New York, US, V. BLATT et
al.: "Substrate fed logic", Seiten 336-342
IBM TECHNICAL DISCLOSURE BULLETIN, Band 21, Nr.
1, Juni 1978, New York, US, S.K. WIEDMANN: "MTL
storage cell", Seiten 231-232

## Beschreibung

Die Erfindung betrifft eine MTL-Speicherzelle (MTL = Merged Transistor Logic) für Speicher mit wahlfreiem Zugriff, die sich durch verbesserte Lesbarkeit und erhöhte Sicherheit gegen Rauschen auszeichnet. Die MTL-Speicherzelle ist auch unter der Bezeichnung I²L-Speicherzelle (I²L = Integrated Injection Logic) bekannt.

Eine konventionelle MTL-Speicherzelle ist in einem Artikel von S.K. Wiedmann in dem IBM Technical Disclosure Bulletin, Band 21, Nr. 1, Juni 1978, Seite 231, beschrieben. Kurz zusammengefasst besteht die MTL-Speicherzelle aus zwei vertikalen NPN-Transistorinvertern, die in der Art eines Flipflops über Kreuz verbunden sind. Die Flipflop-Schaltungsknoten sind jeweils über laterale PNP-Transistoren mit Bitleitungen verbunden. Der Kollektor eines lateralen Transistors und die Basis eines entsprechenden vertikalen Transistors sind im gleichen Halbleitergebiet vom P-Leitungstyp verschmolzen. Ausserdem sind die Basen der lateralen Transistoren und die Emitter der vertikalen Transistoren im gleichen Halbleitergebiet vom N-Leitungstyp verschmolzen, das ausserdem mit einer Wortleitung verbunden ist. Die vertikalen Transistoren werden invers betrieben, d.h. die Emitter werden durch vergrabene Gebiete und die Kollektoren durch ein Gebiet an der Oberfläche der Halbleiterschicht gebildet.

Der Abfühlstrom der MTL-Speicherzelle ergibt eine Spannungsänderung ($\Delta V$) zwischen den Bitleitungen. Diese Spannungsänderung wird abgefühlt, um den Zustand der Speicherzelle festzustellen. Die Grösse der $\Delta V$ bestimmt die Geschwindigkeit und die Sicherheit, mit welcher der Zustand der Speicherzelle insbesondere beim Vorhandensein von Rauschen abgefühlt werden kann. Die MTL-Speicherzelle benötigt jedoch eine bestimmte Wartezeit im Anschluss an die Zellenauswahl, ehe der Sinn der gespeicherten Information zuverlässig ausgelesen werden kann. Obwohl die Wartezeit für viele Anwendungen ausreicht, ist es erwünscht, die Lesezeit zu verkürzen, um die Anwendbarkeit der MTL-Speicherzelle zu erweitern. Es ist ferner erwünscht, diese Verbesserung der Eigenschaften zu erzielen, während die $\Delta V$-Abfühlspannung erhöht wird.

Durch die Fig. 3 der US-A-3 986 178 ist bereits eine MTL-Speicherzelle mit einem Abfühlverstärker bekannt. Dieser Abfühlverstärker besteht aus drei Transistoren Q6, Q7 und Q9. Eine Untersuchung der Eigenschaften dieser Speicherzelle zeigt, dass sie sehr schlechte Ausgangstreibereigenschaften und eine grosse Zugriffsverzögerung hat und dass die Stabilität der Speicherzelle beim Lesen stark vermindert wird.

Durch die Erfindung kann die Lesezeit vermindert und die Änderung der Abfühlspannung erhöht werden, indem der bekannten Vier-Elemente-MTL-Speicherzelle ein zusätzlicher bipolarer Abfühltransistor zugefügt wird. Der Emitter-Kollektor-Pfad des Abfühltransistors ist zwischen die Abfühlleitung und einen der Schaltungsknoten eingeschaltet. Die Basis des Abfühltransistors ist mit dem anderen Schaltungsknoten verbunden. Wenn sich die aufgerufene Speicherzelle im einen Zustand befindet, wird der Abfühltransistor eingeschaltet, um einen Pfad niedriger Impedanz zu erzeugen, der die Spannung auf der Abfühlleitung schnell abfallen lässt. Die Spannungsänderung auf der Abfühlleitung (Abfühlspannung) ist mehr als eine Grössenordnung grösser als bei der konventionellen MTL-Speicherzelle. Darüber hinaus bleibt die Polarität der Abfühlspannung die gleiche während der Übergangsphase, bis sie ihren stabilen Zustand erreicht. Im Gegensatz dazu findet bei der konventionellen MTL-Speicherzelle in der Übergangsphase ein kurzer Wechsel der Polarität der Abfühlspannung statt. Demzufolge ist hier eine minimale Wartezeit nötig, ehe die Abfühlspannung ausgewertet werden kann. Diese Wartezeit ist gemäss der vorliegenden Erfindung entscheidend reduziert.

Die erfindungsgemässe MTL-Speicherzelle mit Abfühlverstärker weist auch deutlich bessere Eigenschaften als die durch die US-A-3 986 178 bekannte Schaltung auf, obwohl sie für den Abfühlverstärker nur einen Transistor anstelle dreier Transistoren benötigt.

Nachfolgend sollen Ausführungsbeispiele der Erfindung anhand der Figuren näher erläutert werden.

Fig. 1 zeigt ein Schaltbild einer konventionellen MTL-Speicherzelle;

Fig. 2 zeigt übliche Wellenformen, die durch die Speicherzelle gemäss Fig. 1 beim Lesen erzeugt werden;

Fig. 3 ist ein Schaltbild einer gemäss der vorliegenden Erfindung verbesserten MTL-Speicherzelle;

Fig. 4 zeigt eine Aufsicht auf das Layout der Speicherzelle eines vorzugsweisen Ausführungsbeispiels der vorliegenden Erfindung, und

Fig. 5 ist ein Querschnitt der Struktur von Fig. 4 entlang der Schnittlinie 5–5.

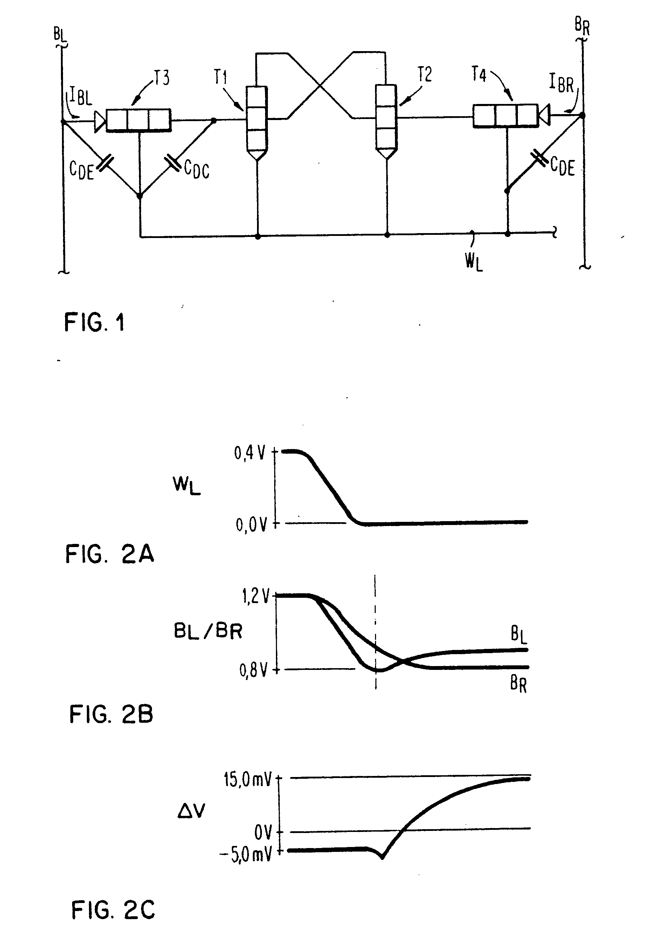

Wie bereits oben erwähnt, tritt bei der konventionellen MTL-Speicherzelle der Fig. 1 eine kurze Umkehr der Richtung der gespeicherten Information unmittelbar nach dem Lesen auf. Die Polarität der Abfühlspannung, die zwischen den Bitleitungen gemessen wird, stellt die Richtung der gespeicherten Information dar. Die störende Umkehr der Richtung kann durch eine Betrachtung des Aufbaus und der Wirkungsweise der bisher bekannten MTL-Speicherzelle der Fig. 1 verstanden werden. Die Speicherzelle besteht aus kreuzgekoppelten, vertikalen MTL-Transistoren T1 und T2, deren Basen jeweils mit Bitleitungen $B_L$ und $B_R$ durch jeweils laterale Eingabe-/Ausgabe-PNP-Transistoren T3 und T4 verbunden sind. Das extrem dichte Layout der Speicherzelle wird durch Verschmelzung des Kollektors eines lateralen Transistors (wie z.B. T3) mit der Basis eines entsprechenden vertikalen Transistors (wie z.B. T1) in das gleiche Halbleitgebiet vom P-Leitungstyp erreicht. Entsprechend sind die Basen der lateralen Transistoren T3 und T4 mit den Emittern der vertikalen Transistoren T1 und T2 und mit der Wortleitung $W_L$ im gleichen vergrabenen Halbleitergebiet vom N-Leitungstyp verschmolzen.

Beim Lesen der vorher in der MTL-Speicherzelle gespeicherten Information wird die Wortleitung $W_L$ um etwa 0,5 Volt auf einen Wert von ungefähr 0 Volt herabgezogen. Gleiche und konstante Leseströme werden den Bitleitungen der ausgewählten Speicherzelle zugeführt. Wenn man annimmt, dass während der Abfühlung der Speicherzelle T1 ein- und T2 ausgeschaltet ist, dann wird T3 in die Sättigung gebracht, wobei Emitter und Kollektor ungefähr die gleiche Spannung von 0,8 Volt aufweisen. Der wesentliche Teil des Stromes, der in den linken Schaltungsknoten aus der Bitleitung $B_L$ gelangt, fliesst über Streukapazitäten $C_{DE}$ und $C_{DC}$ von T3.

Für Wechselstrom können die Kapazitäten $C_{DE}$ und $C_{DC}$ von T3 wegen des gleichen Potentials (0,8 Volt) am Emitter und Kollektor als parallelgeschaltet betrachtet werden. Daraus ergibt sich eine relativ hohe Koppelkapazität zwischen der Wortleitung $W_L$ und der Bitleitung $B_L$. Es ist ferner zu beachten, dass die Grösse der Streukapazität und der durch sie fliessende Strom einander proportional sind und dass, wie oben erwähnt, der wesentliche Teil des Stromes der von der Bitleitung $B_L$ in die Speicherzelle gelangt, durch die parallelen Streukapazitäten $C_{DE}$ und $C_{DC}$ fliesst.

Betrachten wir nun die andere Seite der Speicherzelle, dann stellen wir fest, dass T4 ebenfalls eingeschaltet ist, aber sich nicht im Sättigungszustand befindet. Seine Emitter- und Kollektorpotentiale betragen im gegebenen Beispiel 0,8 bzw. 0 Volt. Infolgedessen fliesst ein Teil des Stromes aus der rechten Bitleitung $B_R$ über den Emitter zum Kollektor von T4, wobei der restliche Strom durch die Streukapazität $C_{DE}$ von T4 fliesst. Da die Ströme, die von $B_L$ und $B_R$ in die Speicherzelle fliessen, gleich sind, ist der Strom durch $C_{DE}$ von T4 kleiner als der Strom durch $C_{DE}$ und $C_{DC}$ von T3. Somit ist die Koppelkapazität zwischen $W_L$ und $B_R$ wesentlich kleiner als die Koppelkapazität zwischen $W_L$ und $B_L$.

Aus den obigen Betrachtungen ergibt sich, dass der Abfall auf der rechten Bitleitung $B_R$ langsamer ist, als der auf der linken Bitleitung $B_L$. Dies folgt aus der Tatsache, dass der Abfall des Potentials auf der Wortleitung $W_L$, wie in Fig. 2A dargestellt, mit $B_R$ über eine Kapazität verkoppelt ist, die kleiner ist als die mit $B_L$ verkoppelte Kapazität. Die entsprechenden Potentiale auf den Bitleitungen $B_L$ und $B_R$ sind in Fig. 2B gezeigt. Der schnelleren Entladung des Potentilas auf $B_L$ folgt eine Erholungsphase, in der das Potential auf einen Wert angehoben wird, der höher ist als das Ruhepotential von $B_R$, nachdem die Leseoperation beendet ist.

Die Abfühlspannung $\Delta V$, in Fig. 2C gezeigt, wird zwischen den zwei Bitleitungen $B_L$ und $B_R$ gemessen. Unmittelbar nach der Auswahl der Speicherzelle wird die Polarität der Abfühlspannung durch die Abfallgeschwindigkeit, mit der die Potentiale auf den Bitleitungen abnehmen, bestimmt. Diese Polarität wird jedoch infolge der Herstellung des Potentials auf $B_L$ umgekehrt, wenn die zwei Bitleitungen ihren jeweiligen Ruhezustand annehmen. Es wird noch einmal daran erinnert, dass $B_L$ mit dem Kollektor des Transistors T2 verbunden ist, da im betrachteten Beispiel angenommen wurde, dass T2 ausgeschaltet ist (und daher sich auf einem höheren Potential befindet). Die Umkehr der Polarität der Abfühlspannung erfordert, dass eine angemessene Zeitspanne verstrichen sein muss, ehe der Zustand der Speicherzelle zuverlässig gelesen werden kann. Die erforderliche Zetispanne hängt ab von der Geschwindigkeit, mit der der laterale PNP-Transistor T3 den Sättigungsstrom herstellt, der durch ihn nach der Auswahl der Speicherzelle fliesst. Wegen der relativ kleinen Geschwindigkeit des lateralen PNP-Transistors wird die Erholung des Potentials auf der linken Bitleitung so lange verzögert, bis der Abfall des Potentials auf der Wortleitung $W_L$ beendet ist.

Für den Lesevorgang der bekannten Speicherzelle der Fig. 1 sei angenommen, dass T1 eingeschaltet und T2 ausgeschaltet ist. Die Auswahl der Speicherzelle erfolgt dadurch, dass das Potential auf der Wortleitung $W_L$ auf etwa 0,4 Volt abgesenkt wird. Lesestrom wird der ausgewählten Speicherzelle über die Bitleitungen zugeführt. Da die Emitter- und Kollektorspannungen von T3 gleich sind, befindet sich dieser Transistor in Sättigung. Sein vorwärts vorgespannter Basisemitterübergang injiziert Träger in das anschliessende gemeinsame Gebiet vom N-Leitungstyp, dessen Träger teilweise von dem Injektionsgebiet vom P-Leitungstyp (Emitter von T3) angezogen werden. Der sich ergebende Strom $I_S$ auf der Bitleitung $B_L$ hängt von der lateralen Stromverstärkung des PNP-Transistors T3 ab und kann zur Feststellung des Zustandes der Speicherzelle abgefühlt werden. $I_S$ ergibt eine Potentialdifferenz $\Delta V$ zwischen den Bitleitungen $B_L$ und $B_R$ gemäss dem Ausdruck:

$$\Delta V = \frac{kT}{q} \ln \frac{1}{1-\alpha_I\alpha_N} \text{ wobei } \frac{kT}{q} \approx 0,026 \text{ Volt,}$$

$\alpha_I$ die Rückwärtsstromverstärkung und $\alpha_N$ die vorwärtsstromverstärkung mit typischen Werten von 0,6 und 0,8 sind. In dem gegebenen Beispiel ist $\Delta V$ nur ungefähr 0,017 Volt.

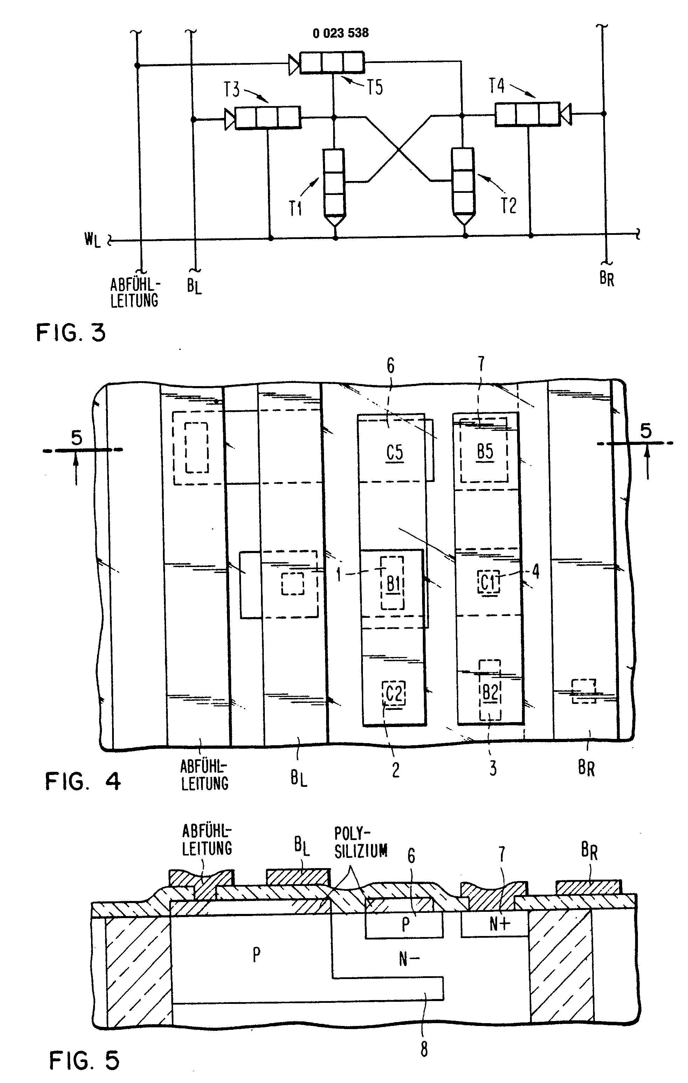

Bei der gemäss der Erfindung modifizierten MTL-Speicherzelle, die in Fig. 3 dargestellt ist, wird jedoch nicht nur die Abfühlgeschwindigkeit gegenüber der bekannten Speicherzelle der Fig. 1 verbessert, sondern auch die Umkehr der Polarität der Abfühlspannung eliminiert. Es wird sich ausserdem zeigen, dass die Amplitude der Abfühlspannung $\Delta V$ ebenfalls vergrössert wird, so dass sich eine bessere Lesbarkeit beim Vorhandensein von Rauschen ergibt. Die Verbindungen der Transistoren T1, T2, T3 und T4 mit den Bitleitungen und der Wortleitung sind in den Speicherzellen der Fig. 3 und 1 die gleichen. Die verbesserte MTL-Speicherzelle der Fig. 3 enthält eine getrennte Abfühlleitung und einen fünften bipolaren Abfühltransistor T5 vom PNP-Typ, dessen Basis und Kollektor mit den jeweiligen Schaltknoten der MTL-Speicherzelle und dessen Emitter mit der Abfühlleitung verbunden sind. Wie im Falle der Fig. 1 sind T1 und T2 der Schaltung gemäss Fig. 3 invertierte NPN-Transistoren, T3 und T4 sind laterale PNP-Transistoren und die Basen von T3 und T4, und die Emitter von T1 und T2 und die Wortleitung sind in einem Halbleitergebiet vom N-Leitungstyp verschmolzen. Der Kollektor von T3 und die Basis von T2 sind in einem Halbleitergebiet vom P-Leitungstyp, der Kollektor von T4 und die Basis von T1 in einem weiteren Halbleitergebiet vom P-Leitungstyp verschmolzen. Der zusätzliche Transistor T5 ist ein vertikaler PNP-Transistor, der über leitende Pfade mit den Schaltknoten der MTL-Speicherzelle und mit der Abfühlleitung verbunden ist, wie später anhand der Fig. 4 und 5 gezeigt. Der Ruhestrom wird der Speicherzelle gemäss Fig. 3 über T3 und T4 durch einen nicht dargestellten Stromgenerator zugeführt, der mit den Bitleitungen verbunden ist. Es wird angenommen, dass beim Lesevorgang der Speicherzelle gemäss Fig. 3 T1 ein- und T2 ausgeschaltet ist. Die Auswahl der Speicherzelle erfolgt durch Absenken des Potentials auf der Wortleitung $W_L$. Der Kollektor von T1 befindet sich auf einem niedrigen Potential, und der Abfühltransistor T5 ist eingeschaltet. Da die zwei Transistoren T1 und T5 eingeschaltet sind, wird ein Pfad niedriger Impedanz zwischen der Wortleitung $W_L$ und der Abfühlleitung erzeugt, der einen schnellen Abfall des Potentials auf der Abfühlleitung bewirkt, wenn die Speicherzelle ausgewählt ist. Wenn T1 aus- und T2 eingeschaltet ist, (der umgekehrte Fall) bestimmt die Zahl der Speicherzellen im entgegengesetzten Zustand, die mit der gleichen Spaltenbitleitung verbunden sind, das Potential auf der Abfühlleitung. Der ungünstigste Fall ist der, dass alle anderen Speicherzellen, die mit der gleichen Spaltenbitleitung verbunden sind, sich in einem Zustand befinden, der entgegengesetzt dem Zustand der ausgewählten Zelle ist. Das niedrigste Potential auf der Abfühlleitung tritt auf, wenn nur T1 der ausgewählten Speicherzelle ausgeschaltet ist. Der geringste Spannungsanstieg $\Delta V$ auf der Abfühlleitung, der ausgenutzt werden kann, um den Zustand der ausgewählten Speicherzelle zu lesen, ist (im ungünstigsten Fall)

$$\Delta V = \Delta V_{WL} - \frac{kT}{q} \ln N$$

wobei $\Delta V_{WL}$ das $\Delta V$ zwischen dem Potential der ausgewählten Wortleitung und dem Potential der unausgewählten Wortleitung ist.

Typische Werte sind 0,4 Volt für $\Delta V_{WL}$ und 0,026 Volt für $\frac{kT}{q}$, wobei N die Zahl der Speicherzellen, z.B. 127, ist, die sich in einem entgegengesetzten Zustand zu dem Zustand der ausgewählten Speicherzelle befinden.

In dem gegebenen Beispiel wäre also ein $\Delta V$ 0,274 Volt, was wesentlich besser ist als ein $\Delta V$ von 0,017 Volt im Falle der bekannten MTL-Speicherzelle. Der Abfühlstrom durch T5 erhöht nicht nur die $\Delta V$-Spannung auf der Abfühlleitung, sondern es findet auch keine Umkehr der Polarität der $\Delta V$-Spannung statt wie in der bekannten MTL-Speicherzelle. Darüber hinaus bewirkt der Abfühlstrom durch T5 eine Verstärkung des Zustandes der ausgewählten Speicherzelle anstatt deren Schwächung. Der Lesevorgang ist also schneller und zuverlässiger insbesondere beim Vorhandensein von Rauschen.

Das Layout der verbesserten Speicherzelle der Fig. 3 ist in Fig. 4 gezeigt und ist ähnlich dem Layout der bekannten Speicherzelle von Fig. 1, wie sie auch in dem oben erwähnten IBM Technical Disclosure Bulletin, Juni 1978, Seite 231, mit Ausnahme der Abfühlleitung und des vertikalen PNP-Transistors T5 (im Querschnitt der Fig. 5 dargestellt) beschrieben ist. Die Bitleitungen $B_L$ und $B_R$ und die Abfühlleitung werden durch Metallisierungen auf einer Isolierschicht gebildet, die einen Halbleiterkörper mit den Transistoren T1, T2, T3, T4 und T5 überzieht. Ein leitender Pfad von polykristallinem Silicium verbindet die Basis 1 von T1 mit dem Kollektor 6 von T5. Die Basis 3 von T2 ist über eine metallische Verbindung mit dem Kollektor 4 von T1 und die Basis 7 von T5 verbunden. Der Kollektor 2 von T2 ist durch eine metallische Verbindung mit der Basis 1 von T1 verbunden. Wie bereits erwähnt, sind die Emitter von T1 und T2, die Wortleitung $W_L$ und die Basen von T3 und T4 in dem gleichen vergrabenen Gebiet vom N-Leitungstyp verschmolzen und erscheinen aus diesem Grund nicht in der Aufsicht der Fig. 4.

T5 ist ausserdem im Querschnitt der Fig. 5 gezeigt, wie T1 und T2 hat auch T5 einen vergrabenen Emitter 8 und einen Kollektor 6, der sich an der Oberfläche des Halbleitersubstrats befindet. Diese Anordnung gestattet die Einfügung des Abfühltransistors T5 in das Layout der bekannten MTL-Speicherzelle bei minimaler Vergrösserung der Fläche in der Speicherzelle in einem unveränderten Herstellungsprozess.

**Patentansprüche**

1. MTL-Speicherzelle mit zwei kreuzgekoppelten Transistoren (T1, T2), zwei Eingabe/Ausgabe-Transistoren (T3, T4), die die Schaltungsknoten mit Bitleitungen (BL, BR) verbinden, einer Wortleitung (WL), deren Potential beim Lesen abgesenkt wird, und einem Abfühlverstärker (T5), der mit einer Abfühlleitung verbunden ist, dadurch gekennzeichnet, dass der Abfühlverstärker aus einem einzigen Transistor (T5) besteht, dessen Kollektor und Basis mit je einem Schaltungsknoten und dessen Emitter mit der Abfühlleitung verbunden ist.

2. MTL-Speicherzelle nach Anspruch 1, dadurch gekennzeichnet, dass der Abfühltransistor (T5) und die Eingabe/Ausgabe-Transistoren (T3, T4) PNP-Transistoren und die kreuzgekoppelten Transistoren (T1, T2) NPN-Transistoren sind.

3. MTL-Speicherzelle nach Anspruch 1 oder 2, dadurch gekennzeichnet, dass die kreuzgekoppelten NPN-Transistoren (T1, T2) inverse, vertikale Transistoren sind.

4. MTL-Speicherzelle nach einem der Ansprüche 1 bis 3, dadurch gekennzeichnet, dass die Eingabe-Ausgabe-Transistoren (T3, T4) laterale Transistoren sind.

5. MTL-Speicherzelle nach einem der Ansprüche 1 bis 4, dadurch gekennzeichnet, dass der Abfühltransistor (T5) ein vertikaler Transistor ist.

6. MTL-Speicherzelle nach einem der Ansprüche 1 bis 5, dadurch gekennzeichnet, dass die Basen der Eingabe-Ausgabe-Transistoren (T3, T4), die Emitter der kreuzgekoppelten NPN-Transistoren (T1, T2) und die Wortleitung in einem Halbleitergebiet vom N-Leitungstyp verschmolzen sind.

7. MTL-Speicherzelle nach einem der Ansprüche 1 bis 6, dadurch gekennzeichnet, dass je ein Kollektor der Eingabe-Ausgabe-Transistoren (T3, T4) und die Basis der zugeordneten kreuzgekoppelten NPN-Transistoren (T1, T2) in einem Halbleitergebiet vom P-Leitungstyp verschmolzen sind.

## Claims

1. MTL cell with two cross-coupled transistors (T1, T2), two input/output transistors (T3, T4) connecting the nodes with bit lines (BL, BR), one word line (WL) whose potential is lowered during reading, and one sense amplifier (T5) connected to a sense line, characterized in that the sense amplifier consists of one single transistor (T5) whose collector and base are each connected to one node, and whose emitter is connected to the sense line.

2. MTL cell as claimed in claim 1, characterized in that the sense transistor (T5) and the input/output transistors (T3, T4) are PNP transistors, and the cross-coupled transistors (T1, T2) are NPN transistors.

3. MTL cell as claimed in any one of claims 1 or 2, characterized in that the cross-coupled NPN transistors (T1, T2) are inverse, vertical transistors.

4. MTL cell as claimed in any one of claims 1 to 3, characterized in that the input/output transistors (T3, T4) are lateral transistors.

5. MTL cell as claimed in any one of claims 1 to 4, characterized in that the sensing transistor (T5) is a vertical transistor.

6. MTL cell as claimed in any one of claims 1 to 5, characterized in that the bases of the input/output transistors (T3, T4), the emitters of the cross-coupled NPN transistors (T1, T2) and the word line are merged in a semiconductor region of the N-Type.

7. MTL cell as claimed in any one of claims 1 to 6, characterized in that one respective collector of the input/output transistors (T3, T4) and the base of the associated cross-coupled NPN transistors (T1, T2) are merged in a semiconductor region of the P-type.

## Revendications

1. Cellule à mémoire MTL comportant deux transistors couplés en croix (T1, T2), deux transistors entrée-sortie (T3, T4) reliant les nœuds du circuit avec des lignes de bit (BL, BR), une ligne de mot (WL) dont le potentiel est abaissé pendant la lecture et un amplificateur de détection (T5) relié à une ligne de détection, caractérisée en ce que ledit amplificateur de détection est composé d'un seul transistor (T5) dont le collecteur et la base sont respectivement reliés à un nœud du circuit et dont l'émetteur est relié à ladite ligne de détection.

2. Cellule à mémoire MTL selon la revendication 1, caractérisée en ce que ledit transistor de détection (T5) et lesdits transistors entrée-sortie (T3, T4) sont des transistors PNP et lesdits transistors couplés en croix (T1, T2) sont des transistors NPN.

3. Cellule à mémoire MTL selon la revendication 1 ou 2, caractérisée en ce que les transistors couplés en croix NPN (T1, T2) sont des transistors verticaux exploités en mode inverse.

4. Cellule à mémoire MTL selon une quelconque des revendications 1 à 3, caractérisée en ce que lesdits transistors entrée-sortie (T3, T4) sont des transistors latéraux.

5. Cellule à mémoire MTL selon une quelconque des revendications 1 à 4, caractérisée en ce que le transistor de détection (T5) est un transistor vertical.

6. Cellule à mémoire MTL selon une quelconque des revendications 1 à 5, caractérisée en ce que les bases desdits transistors entrée-sortie (T3, T4), les émetteurs desdits transistors NPN couplés en croix (T1, T2) et la ligne de mot sont intégrés dans une même région semi-conductrice de conductivité de type N.

7. Cellule à mémoire MTL selon une quelconque des revendications 1 à 6, caractérisée en ce qu'un collecteur respectivement desdits transistors entrée-sortie (T3, T4) et la base desdits transistors NPN couplés en croix (T1, T2) sont intégrés dans une même région semi-conductrice de conductivité de type P.

FIG. 1

FIG. 2A

FIG. 2B

FIG. 2C

FIG. 3

FIG. 4

FIG. 5

9